(19) Europäisches Patentamt
European Patent Office
Office européen des brevets

(11) **EP 3 921 462 B1**

(12) **FASCICULE DE BREVET EUROPEEN**

(45) Date de publication et mention de la délivrance du brevet:
**12.04.2023 Bulletin 2023/15**

(21) Numéro de dépôt: **20702507.3**

(22) Date de dépôt: **06.02.2020**

(51) Classification Internationale des Brevets (IPC):
**C30B 15/10** (2006.01)  **C30B 15/14** (2006.01)
**C30B 15/30** (2006.01)  **C30B 29/06** (2006.01)
**C30B 35/00** (2006.01)  **F27B 14/10** (2006.01)
**H05B 6/24** (2006.01)

(52) Classification Coopérative des Brevets (CPC):
**C30B 35/002; C30B 15/10; C30B 15/305; F27B 14/10; H05B 6/24;** F27B 2014/108

(86) Numéro de dépôt international:
**PCT/EP2020/053051**

(87) Numéro de publication internationale:
**WO 2020/161269 (13.08.2020 Gazette 2020/33)**

(54) **CREUSET FROID**

KALTSCHMELZTIEGEL

COLD CRUCIBLE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.02.2019 FR 1901244**

(43) Date de publication de la demande:
**15.12.2021 Bulletin 2021/50**

(73) Titulaires:
• **Institut Polytechnique de Grenoble**
  **38000 Grenoble (FR)**
• **Centre national de la recherche scientifique**
  **75016 Paris (FR)**
• **Université Grenoble Alpes**
  **38400 Saint-Martin-d'Hères (FR)**

(72) Inventeurs:
• **ZAIDAT, Kader**
  **38400 Saint Martin d'Heres (FR)**
• **GARNIER, Christian**
  **38320 Eybens (FR)**
• **HASAN, Ghatfan**
  **38400 Saint Martin d'Heres (FR)**

(74) Mandataire: **Hautier IP**
  **20, rue de la Liberté**
  **06000 Nice (FR)**

(56) Documents cités:
WO-A1-2017/093165    DE-A1- 10 042 151
JP-A- H1 152 095    US-A- 5 109 389
US-A1- 2007 147 463

# Description

## DOMAINE TECHNIQUE

L'invention concerne le domaine des creusets froids. Elle trouve pour application particulièrement avantageuse le domaine de l'élaboration de matériaux à haute température.

De façon connue, un creuset froid comprend :

- une cage dite froide comprenant des secteurs en un matériau bon conducteur électrique, généralement en cuivre, et dans laquelle une charge à fondre est destinée à être introduite, et
- un dispositif de refroidissement à fluide caloporteur, généralement de l'eau,

le dispositif de refroidissement étant configuré pour refroidir, de l'intérieur, chaque segment de la cage froide.

Chaque creuset froid utilise, pour fonctionner, une spire extérieure d'induction électromagnétique entourant la cage froide et dans laquelle un courant alternatif circule.

Chaque creuset froid peut en outre être utilisé avec un dispositif d'alimentation en continu du matériau constitutif de la charge.

## ÉTAT DE LA TECHNIQUE

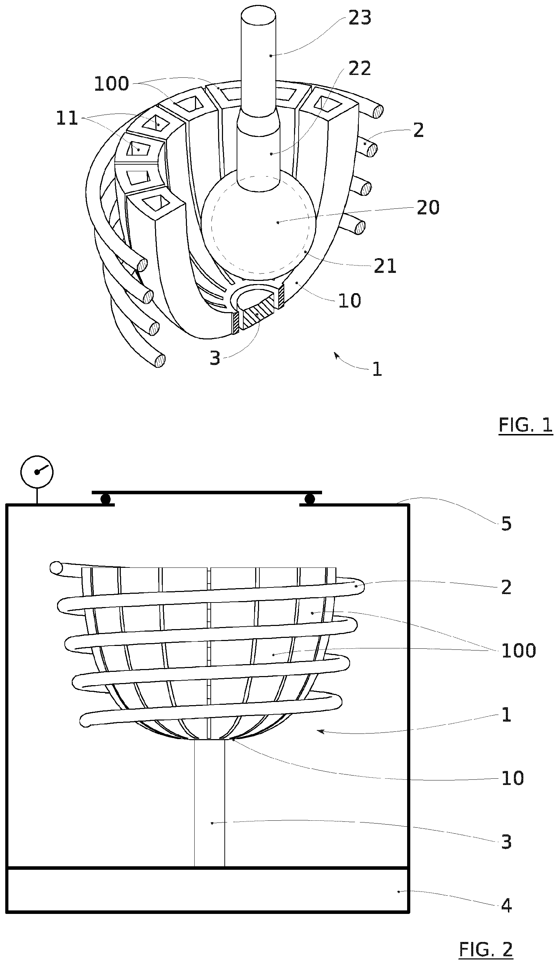

Il existe plusieurs types de creusets froids dont deux sont illustrés sur les figures 1 et 2 annexées. D'autres types de creusets froids existent qui ne sont pas illustrés ici qui comprennent par exemple les modèles dits à double creuset. Quel que soit le type de creuset considéré, son principe de fonctionnement est sensiblement commun aux autres ; il est tel qu'introduit ci-dessous en référence aux figures 1 et 2.

Le creuset froid 1 et la spire 2 sont placés dans une enceinte hermétique 5 à atmosphère contrôlé, de préférence exempt d'oxygène, souvent remplie d'un gaz inerte tel que de l'Argon, à une pression déterminée. Toutefois l'élaboration de matériaux en creuset froid peut aussi être utilisée sous une atmosphère oxygénée.

Lorsque l'on injecte un courant alternatif dans la spire 2 entourant la cage froide 10, il apparaît des courants induits dans chacun des secteurs 100 refroidis de la cage, ces courants produisent à leurs tours un courant de Foucault dans l'épaisseur de peau, dite électromagnétique, d'une charge 20 située dans la cage. Ces courants de Foucault permettent de chauffer la charge 20, le cas échéant jusqu'à sa fusion, sans pour autant que le creuset froid 1 ne chauffe.

Bien entendu, le chauffage de la charge étant obtenue par induction électromagnétique, il faut que la charge 20 soit conductrice électriquement. L'épaisseur de peau électromagnétique 21 de la charge 20 est fonction de la résistivité de cette charge et de la fréquence utilisée pour le courant alternatif injecté dans la spire 2.

Notons que cette peau électromagnétique 21 est la partie de la charge 20 située au plus près de la cage froide 10.

Le creuset froid 1 peut en outre être utilisé pour fondre des matériaux semi-conducteurs. À cette fin, le creuset froid 1 est mis en oeuvre, de façon connue, avec un dispositif de préchauffage de la charge 20 pour la rendre conductrice. Ce dispositif de préchauffage (non représenté) comprend généralement un couvercle en graphite agencé au-dessus du creuset froid 1 et le cas échéant muni d'un système de ventilation à flux de gaz configuré pour éviter toute pollution de la charge 20 par le graphite du couvercle.

Les avantages connus de cette technologie sont : la lévitation de la charge 20 en fusion qui explique notamment la relative inusabilité des creusets froids 1, la potentielle absence de pollution extérieure (notamment par de l'oxygène ou du graphite) dans les matériaux 22 élaborés et un brassage de la charge 20 en fusion permettant l'élaboration de matériaux 22, et notamment d'alliage, de très bonne homogénéité.

Les creusets froids sont actuellement utilisés pour l'élaboration d'alliages métalliques, par exemple à base de Titane, Nobium, etc. L'utilisation des creusets froids dans la métallurgie est effectivement devenue un outil très apprécié pour sa qualité de brassage qui permet d'obtenir des alliages très homogènes en composition. Cette homogénéité est assurée par un brassage virulent dû à la présence d'une force électromagnétique très grande, notamment observable dans l'épaisseur de la peau électromagnétique de la charge en fusion.

Il suffit de couper le courant alternatif circulant dans la spire 2 de sorte à arrêter la lévitation de la charge 20 en fusion, tout en retirant un bouchon 3 bouchant jusque-là le fond du creuset froid 1, de la façon illustrée sur la figure 1, pour que la charge en fusion coule dans un moule situé sous le creuset froid.

En référence à la figure 1, l'utilisation de creusets froids 1 a également été envisagée pour élaborer des monocristaux, notamment des matériaux semi-conducteurs. Cette technique utilise un germe parfaitement monocristallin pour initier la croissance de lingots monocristallins 22. Le germe 23 est introduit dans la charge 20 en fusion du matériau à cristalliser, puis l'ensemble composé du germe 23 et du monocristal 22 en croissance sur le germe 23 et déplacé vers le haut (Cf. figure 1) ou vers le bas (Cf. figure 2, et notamment les éléments référencés 3 (doigt refroidi) et 4 (plateau de translation verticale)) pour faire croître le monocristal 22 en longueur, et idéalement en diamètre.

Par ailleurs, des creusets froids sont décrits par les documents de brevet référencés DE 100 42 151 A1, US 2007/0147463 A1, JP H11 52095 A, US 5,109,389 et WO 2017/093165 A1.

Un inconvénient des creusets froids existants est qu'ils ne permettent pas, ou du moins pas facilement, de réaliser d'autres fonctions que celle qui leur est classiquement reconnue. Plus particulièrement, un creuset froid existant n'a souvent pour seule fonction que de permettre la fusion de la charge qu'il contient.

Un objet de la présente invention est donc de proposer un creuset froid permettant de pallier au moins en partie les inconvénients susmentionnés. Un objet de la présente invention est plus particulièrement de proposer un creuset froid permettant de réaliser d'autres fonctions que celle qui leur est classiquement reconnue et qui consiste à permettre la fusion de la charge qu'il contient.

Les autres objets, caractéristiques et avantages de la présente invention apparaîtront à l'examen de la description suivante et des dessins d'accompagnement. Il est entendu que d'autres avantages peuvent être incorporés.

RÉSUMÉ

Pour atteindre cet objectif, selon un mode de réalisation, la présente invention prévoit un creuset froid, par ailleurs conforme à la définition générique qu'en donne le préambule ci-dessus, essentiellement tel qu'au moins un secteur du creuset froid comprend un logement dit de (multi)fonctionnalisation et est amovible. Le logement de (multi)fonctionnalisation est propre et destiné à y loger au moins un dispositif de (multi)fonctionnalisation du secteur qui le comprend, et plus généralement du creuset froid lui-même. Le dispositif de (multi)fonctionnalisation peut être compris par le secteur qui le loge, et plus généralement par le creuset froid lui-même. Plus particulièrement, ledit au moins un secteur du creuset froid est amovible depuis au moins l'un parmi le dispositif de refroidissement et au moins un autre secteur du creuset froid.

Le cas échéant, le creuset froid comprend en outre un dispositif de fixation et de maintien d'au moins un secteur, de préférence de chaque secteur, à l'un au moins parmi le dispositif de refroidissement et au moins un autre secteur. Le dispositif de fixation et de maintien est configuré de sorte que ledit au moins un secteur une fois fixé et maintenu forme une partie de la cage froide.

Il est dès lors possible de (multi)fonctionnaliser ledit au moins un secteur indépendamment des autres, en logeant, dans le logement qu'il comprend, au moins un dispositif de (multi)fonctionnalisation. Un dispositif de (multi)fonctionnalisation peut être défini, sans être nécessairement limité à cette définition, comme un dispositif configuré pour modifier et/ou analyser au moins une propriété de la charge, notamment en fusion, dans la cage froide. Le dispositif de (multi)fonctionnalisation peut comprendre, voire être constitué de, un dispositif de modification et/ou d'analyse d'au moins une propriété de la charge. De façon non limitative, le dispositif de (multi)fonctionnalisation peut être l'un parmi :

- un dispositif de génération d'un champ électromagnétique, de préférence un aimant permanent,
- une ferrite,
- un dispositif de chauffage complémentaire (microonde, infrarouge, ultraviolet...),
- un transducteur ultrasonore et
- un dispositif piézoélectrique.

L'on comprend également que le creuset froid ainsi multifonctionnalisé présente une grande modularité. En effet, de nombreuses combinaisons entre secteurs et dispositifs de (multi)fonctionnalisation sont envisageables, procurant potentiellement chacune une ou plusieurs modifications ou analyses particulières de la charge.

Le creuset froid selon l'invention permet non seulement de rendre les secteurs actifs dans le contrôle ou la caractérisation de la charge, notamment en fusion, mais aussi d'en diminuer le coût de fabrication et le coût de maintenance.

Le dispositif de refroidissement comprenant un canal de circulation du fluide caloporteur configuré pour permettre le refroidissement de la cage froide et s'étendant en partie dans au moins un secteur, de préférence dans chaque secteur, le logement de (multi)fonctionnalisation peut être en communication, voire ne former qu'un logement, avec la partie du canal de circulation s'étendant dans le secteur. Un avantage de cette configuration est que le dispositif de refroidissement peut alors servir à refroidir non seulement le secteur, comme auparavant, mais également le dispositif de (multi)fonctionnalisation.

En alternative, le logement de (multi)fonctionnalisation peut être distinct de la partie du canal de circulation s'étendant dans le secteur. Cette configuration alternative est à privilégier lorsqu'un contact entre le fluide caloporteur et le dispositif de (multi)fonctionnalisation est à éviter. Plus particulièrement, un tel contact peut rendre le dispositif de (multi)fonctionnalisation dysfonctionnel, ou moins fiable, précis, actif, etc.

De préférence, le dispositif de (multi)fonctionnalisation est constitué à base d'un matériau moins bon conducteur électrique que le matériau, en général du cuivre, à base duquel les secteurs sont constitués. De la sorte, chaque dispositif de (multi)fonctionnalisation logé à l'intérieur d'un secteur ne subit pas d'effet du champ magnétique.

En alternative ou en complément, le dispositif de (multi)fonctionnalisation peut être agencé conjointement avec un support, plus particulièrement un adaptateur, constitué à base d'un matériau moins bon conducteur électrique que le matériau, en général du cuivre, à base duquel les secteurs sont constitués. Par exemple, le support est configuré pour isoler électriquement le dispositif de (multi)fonctionnalisation et le secteur qui le loge entre eux. Ledit support permet ainsi au secteur de jouer son rôle de blindage électromagnétique, même si le dispositif de (multi)fonctionnalisation est constitué à base d'un matériau aussi bon conducteur électrique, voire meilleur conducteur électrique, que le matériau à base duquel les secteurs sont constitués.

Ledit support est de préférence configuré pour adapter (ou ajuster) ledit au un dispositif de (multi)fonctionnalisation au logement de (multi)fonctionnalisation destiné à le loger. Les logements de fonctionnalisation peuvent dès lors être de taille et de forme standardisées. La fabrication du creuset froid selon l'invention s'en trouve faciliter et son coût réduit.

Lorsque le dispositif de (multi)fonctionnalisation comprend, ou est constitué de, une ferrite, il peut être configuré pour concentrer les lignes de champ électromagnétique situées en périphérie du secteur qui le loge. Plusieurs secteurs pouvant loger un tel dispositif de (multi)fonctionnalisation, il est dès lors possible de concentrer les lignes de champ électromagnétique dans certains endroits du creuset froid, de façon indépendante et modulable, car chacun des secteurs est indépendant.

Lorsque le dispositif de (multi)fonctionnalisation comprend, ou est constitué de, un transducteur ultrasonore, il peut être configuré pour caractériser la charge en fusion en mesurant les vitesses de déplacement de la matière en son sein.

Lorsque le dispositif de (multi)fonctionnalisation comprend, ou est constitué de, un dispositif piézoélectrique, il peut être configuré pour introduire des ondes de pressions à l'intérieur de la charge, notamment en fusion.

Lorsque le dispositif de (multi)fonctionnalisation comprend, ou est constitué de, un dispositif de chauffage complémentaire (micro-ondes, infra-rouge, ultraviolet) choisi en fonction des caractéristiques du matériau à élaborer, il peut être configuré de sorte à produire, à travers la paroi du doigt froid, un chauffage paramétré pour augmenter les caractéristiques thermiques de la charge.

Lorsque le dispositif de (multi)fonctionnalisation comprend, ou est constitué de, un dispositif de génération d'un champ électromagnétique, il peut être configuré pour générer un champ électromagnétique, de préférence un champ magnétique statique (ou quasi-statique), dans la charge, notamment en fusion, et en particulier dans une épaisseur de peau électromagnétique de la charge en fusion.

Chaque dispositif de génération peut plus particulièrement être configuré pour générer un champ électromagnétique, et de préférence un champ magnétique statique, de densité suffisante pour être ressenti par la charge en fusion dans la cage froide, et plus particulièrement au moins, voire uniquement, dans une épaisseur de peau électromagnétique de la charge en fusion dans la cage froide. Chaque champ électromagnétique peut dès lors avoir pour effet de freiner le brassage électromagnétique de la charge en fusion.

Dès lors, le creuset froid selon cette dernière caractéristique permet de réaliser successivement des lingots monocristallins de diamètre significativement plus grand relativement au diamètre du germe permettant d'initier leur croissance. De tels lingots monocristallins peuvent être réalisés en divers matériaux conducteurs ou semi-conducteurs. Des tranches (ou wafers) découpées dans des lingots monocristallins en matériaux semi-conducteurs ainsi réalisés peuvent avantageusement trouver à s'appliquer dans de nombreux domaines, et notamment dans le domaine de l'électronique de puissance.

Chaque dispositif de génération d'un champ magnétique peut plus spécifiquement être configuré pour générer un champ électromagnétique, et de préférence un champ magnétique statique, présentant une densité sensiblement supérieure à 0,02 T, de préférence sensiblement supérieure à 0,05 T, à une distance sensiblement supérieure à 2 mm depuis un de ses bords orienté vers l'intérieur de la cage froide.

Par exemple, chaque dispositif de génération d'un champ magnétique est configuré pour générer un champ électromagnétique, et de préférence un champ magnétique statique, présentant une densité sensiblement comprise entre 0,07 et 0,8 T (plus préférentiellement sensiblement comprise entre 0,1 et 0,3 T), à une distance sensiblement comprise entre 0,1 et 12 mm du dispositif de génération (plus préférentiellement sensiblement comprise entre 4 et 10 mm) depuis un de ses bords orienté vers l'intérieur de la cage froide.

Chaque dispositif de génération est plus particulièrement logé dans son secteur de sorte à se situer, par un de ses bords orienté vers l'intérieur de la cage froide, à une distance sensiblement inférieure à 12 mm, de préférence sensiblement inférieure à 9 mm, et encore plus préférentiellement sensiblement inférieure à 6 mm, de la charge en fusion dans le creuset froid.

Chaque secteur étant à base d'un matériau peu résistif, en général en cuivre, sert de bouclier (électromagnétique) pour protéger le dispositif de génération qu'il loge. En effet, les courants induits dans les secteurs passent ainsi naturellement dans l'épaisseur des parois, par exemple en cuivre, des secteurs.

En outre, chaque dispositif de génération est configuré dans le secteur qui le loge de sorte à être refroidi par le dispositif de refroidissement du creuset froid. Un même dispositif de refroidissement peut permettre de garantir le maintien d'une température contrôlée des dispositifs de génération et des secteurs.

Selon un mode de réalisation préféré de l'invention, au moins un dispositif de génération comprend au moins un aimant permanent. L'agencement conjoint de chaque aimant permanent avec le dispositif de refroidissement est alors plus particulièrement configuré pour garantir le maintien de l'aimant permanent à une température toujours inférieure, à la température de Curie au-delà de laquelle l'aimant perd son aimantation. De préférence, chaque aimant permanent est plus particulièrement tel qu'il génère un champ magnétique statique d'une densité sensiblement égale à 0,8 T à 2 mm de distance de ses bords. Chaque aimant permanent est de préférence constitué en un matériau présentant une résistivité électrique supérieure à celle du matériau constitutif des secteurs de la cage froide. Chaque aimant permanent est par exemple en un matériau à base de Fer et/ou de Néodyme.

Selon un mode de réalisation préféré de l'invention, au moins un dispositif de génération d'un champ magnétique statique comprend une pluralité d'aimants permanents. Les aimants permanents de chaque pluralité sont de préférence agencés entre eux de sorte à générer, au moins en direction de l'intérieur de la cage froide, un champ magnétique statique plus puissant, en termes de valeur de champ magnétique que le champ magnétique statique généré par chaque aimant permanent pris isolément. Les aimants permanents de chaque pluralité sont par exemple agencés entre eux selon une configuration dite de Halbach.

De manière facultative, l'invention peut en outre présenter au moins l'une quelconque des caractéristiques suivantes :

- Selon un mode de réalisation de l'invention, le dispositif de fixation et de maintien comprend une base, en général en acier inoxydable, configurée pour y fixer de façon amovible chaque secteur du creuset froid de sorte que les secteurs et la base forment ensemble la cage froide. De préférence, la fixation de chaque secteur sur la base est configurée pour permettre la circulation du fluide caloporteur du dispositif de refroidissement à travers la base dans le secteur. Un joint d'étanchéité, prenant par exemple la forme d'un joint de culasse ou d'un joint torique, peut le cas échéant être agencé entre la base et les secteurs, ou directement entre les secteurs et le dispositif de refroidissement, notamment en l'absence de base ;

- De préférence, au moins un dispositif de (multi)fonctionnalisation comprend une première partie configurée pour fonctionnaliser le creuset froid et une deuxième partie, dite partie de support, configurée pour supporter la première partie du dispositif de (multi)fonctionnalisation et pour coopérer étroitement avec le logement du dispositif de (multi)fonctionnalisation dans le secteur. De préférence, la partie de support du dispositif de (multi)fonctionnalisation est configurée pour supporter une pluralité d'aimants permanents, par exemple agencés entre eux selon une configuration dite de Halbach. En alternative, ou en complément, le support est configuré pour former avec les parois intérieures de son logement dans le secteur, et le cas échéant avec la première partie du dispositif de (multi)fonctionnalisation qu'il supporte, un couloir de circulation pour le fluide caloporteur du dispositif de refroidissement ;

- Selon un mode de réalisation particulier, seuls deux secteurs opposés l'un à l'autre logent un dispositif de (multi)fonctionnalisation tel qu'introduit ci-dessus ;

- Selon un autre mode de réalisation particulier, seuls trois secteurs agencés sensiblement selon une symétrie de rotation d'ordre 3 logent un dispositif de (multi)fonctionnalisation tel qu'introduit ci-dessus ;

- Selon un autre mode de réalisation particulier, seuls quatre secteurs agencés sensiblement selon une symétrie de rotation d'ordre 4 logent un dispositif de (multi)fonctionnalisation tel qu'introduit ci-dessus ;

- Selon un autre mode de réalisation particulier, un secteur sur deux secteurs adjacents loge un dispositif de (multi)fonctionnalisation tel qu'introduit ci-dessus ;

- Selon un autre mode de réalisation particulier, chaque secteur loge un dispositif de (multi)fonctionnalisation tel qu'introduit ci-dessus.

BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

La figure 1 représente schématiquement une vue en perspective d'un creuset froid selon l'art antérieur ouvert en deux, agencé conjointement avec une spire d'induction électromagnétique et comprenant une charge depuis laquelle un germe est progressivement retiré pour faire croître un monocristal ;

La figure 2 représente schématiquement une vue de face en transparence d'une enceinte hermétique contenant un creuset froid selon un autre art antérieur que celui illustré sur la figure 1 ;

La figure 3 représente une vue en perspective d'un mode de réalisation préféré du creuset froid selon l'invention équipé d'un dispositif de refroidissement ;

La figure 4 est une vue en perspective et en éclaté du creuset froid et du dispositif de refroidissement illustré sur la figure 3, avec un dispositif de génération de champ magnétique statique en tant que dispositif de (multi)fonctionnalisation ;

La figure 5 est une vue en perspective d'un dispositif de génération de champ magnétique statique selon le mode de réalisation préféré de l'invention ;

La figure 6 est une vue en perspective par le dessous d'un secteur selon le mode de réalisation préféré de l'invention ;

La figure 7 est une vue en perspective et en transparence du secteur illustré sur la figure 6 ;

La figure 8 est une représentation schématique d'un agencement d'aimants permanents selon une configuration de Halbach et des lignes isomagnétiques produites par cet agencement ; et

Les figures 9 et 10 sont des résultats de simulation d'un modèle multi-physique démontrant l'efficacité du creuset froid selon l'invention (figure 10) (dont au moins un secteur loge un dispositif de génération d'un champ électromagnétique) relativement à celle d'un creuset froid selon l'art antérieur (figure 9).

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

## DESCRIPTION DÉTAILLÉE

On entend par « inférieur » et « supérieur », « inférieur ou égal » et supérieur ou égal », respectivement. L'égalité est exclue par l'usage des termes « strictement inférieur » et « strictement supérieur ». Egalement, les expressions du type « égal, inférieur, supérieur » s'entendent de comparaisons pouvant accommoder certaines tolérances, notamment selon l'échelle de grandeur des valeurs comparées et les incertitudes de mesure. Des valeurs sensiblement égales, inférieures ou supérieures entrent dans le cadre d'interprétation de l'invention.

On entend par un paramètre « sensiblement égal/supérieur/inférieur à » une valeur donnée que ce paramètre est égal/supérieur/inférieur à la valeur donnée, à plus ou moins 20 %, voire 10 %, près de cette valeur. On entend par un paramètre « sensiblement compris entre » deux valeurs données que ce paramètre est au minimum égal à la plus petite valeur donnée, à plus ou moins 20 %, voire 10 %, près de cette valeur, et au maximum égal à la plus grande valeur donnée, à plus ou moins 20 %, voire 10 %, près de cette valeur.

Il est précisé que, dans le cadre de la présente invention, le terme « sur », « surmonte », « recouvre » ou « sous-jacent » ou leurs équivalents ne signifient pas forcément « au contact de ».

On entend par « agencé conjointement avec » la relation fonctionnelle de deux éléments structurels entre eux selon laquelle l'un des deux éléments est agencé en fonction de l'autre élément. En particulier, l'un des éléments peut être agencé en fonction des dimensions et formes de l'autre élément et/ou selon une disposition particulière définie par rapport à une implantation de l'autre élément, pour réaliser ensemble une fonction particulière. Ces termes visent donc à couvrir une multitude d'agencements relatifs de deux éléments structurels entre eux, multitude qu'il serait nécessairement vain de vouloir détailler exhaustivement.

On entend par un élément à base d'un matériau A, un élément comprenant ce matériau A et éventuellement d'autres matériaux.

On entend par « champ électromagnétique », un champ représenté par l'ensemble $(\vec{E},\vec{B})$, où $\vec{E}$ est le champ électrique et $\vec{B}$ est le champ magnétique, tel qu'une particule de charge $q$ et de vecteur vitesse $\vec{v}$ subit une force qui s'exprime par :

$$\vec{F} = q\big(\vec{E} + [\vec{v}\wedge\vec{B}]\big)$$

La définition du champ électromagnétique comprend ici celle d'un champ magnétique, et a *fortiori* celle d'un champ magnétique statique, qui constituent des cas particuliers de champ électromagnétique.

On entend, par une configuration de Halbach, un arrangement spécial d'aimants permanents qui augmentent le champ magnétique d'un côté de l'arrangement tout en annulant quasiment le champ de l'autre côté.

On entend, par matériau bon conducteur électrique, un matériau dont la résistivité électrique est sensiblement inférieure à $6.10^{-8}$ ohm.m, de préférence sensiblement inférieure à $2.10^{-8}$ ohm.m.

Comme mentionné en introduction, un objet de la présente invention est de proposer un creuset froid permettant de réaliser d'autres fonctions que celle qui leur est classiquement reconnue et qui consiste à permettre la fusion de la charge qu'il contient.

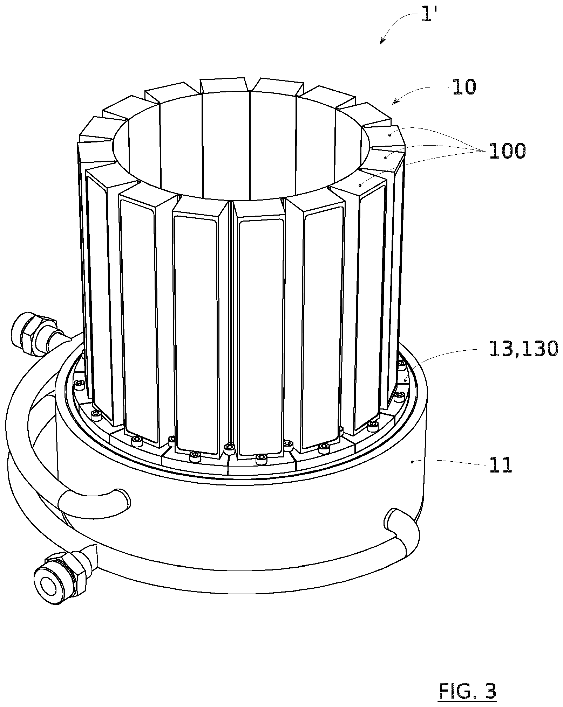

Pour ce faire, l'invention propose plus particulièrement un creuset froid 1', tel que par exemple illustré sur la figure 3, qui, contrairement à un creuset froid classique 1, est essentiellement tel qu'au moins un de ses secteurs, de préférence chacun de ses secteurs 100, comprend un logement dit de (multi)fonctionnalisation 101 et est amovible.

Le logement de (multi)fonctionnalisation 101 est propre et destiné à y loger au moins un dispositif de (multi)fonctionnalisation 12 du secteur 100 qui le comprend. Ledit au moins un dispositif de (multi)fonctionnalisation 12 peut être compris dans le creuset froid 1' selon l'invention. En alternative, un dispositif de (multi)fonctionnalisation 12 peut être fourni comme un accessoire d'un creuset froid selon l'invention. L'invention est donc tout à fait adaptable à différents dispositifs de (multi)fonctionnalisation 12 dont des exemples sont présentés plus bas.

Plus particulièrement, au moins un secteur 100 du creuset froid 1', de préférence chaque secteur du creuset froid, est amovible depuis au moins l'un parmi le dispositif de refroidissement 11 et au moins un autre secteur 100 du creuset froid 1'. De préférence, chaque secteur 100 du creuset froid est amovible depuis au moins l'un parmi le dispositif de refroidissement 11 et chaque autre secteur 100 du creuset froid.

Le cas échéant, le creuset froid 1' comprend en outre un dispositif de fixation et de maintien 13, 130 d'au moins un secteur 100, de préférence de chaque secteur, à l'un au moins parmi le dispositif de refroidissement 11 et au moins un autre secteur 100. Le dispositif de fixation et de maintien 13, 130 peut plus particulièrement être configuré de sorte que ledit au moins un secteur 100 une fois fixé et maintenu forme au moins une partie de la cage froide 10.

Il est dès lors possible de (multi)fonctionnaliser chaque secteur, indépendamment des autres, en logeant, dans le logement de (multi)fonctionnalisation 101 qu'il comprend, au moins un dispositif de (multi)fonctionnalisation 12 choisi. Un dispositif de (multi)fonctionnalisation 12 peut être défini, sans être nécessairement limité à cette définition, comme un dispositif permettant de modifier ou analyser au moins une propriété de la charge, notamment en fusion, dans la cage froide.

De façon non limitative, le dispositif de (multi)fonctionnalisation 12 peut être l'un parmi : un dispositif de génération 120 d'un champ électromagnétique, de préférence un aimant permanent, une ferrite, un transducteur ultrasonore et un dispositif piézoélectrique.

L'on comprend également que le creuset froid 1' ainsi multifonctionnalisé présente une grande modularité. En effet, de nombreuses combinaisons entre secteurs 100 et dispositifs de (multi)fonctionnalisation 12 sont envisageables, procurant potentiellement chacune une ou plusieurs modifications ou analyses particulières de la charge 20.

Le creuset froid 1' selon l'invention permet de rendre les secteurs actifs dans le contrôle ou la caractérisation de la charge, notamment en fusion.

Le dispositif de refroidissement 11 comprenant un canal de circulation du fluide caloporteur (typiquement de l'eau) configuré pour permettre le refroidissement de la cage froide et s'étendant en partie dans chaque secteur 100, le logement de (multi)fonctionnalisation 101 peut être en communication, voire ne former qu'un logement, avec la partie du canal de circulation s'étendant dans le secteur. Un avantage de cette configuration est que le dispositif de refroidissement 11 peut alors servir à refroidir non seulement le secteur 100, comme auparavant, mais également le dispositif de (multi)fonctionnalisation 12. Ceci est particulièrement avantageux lorsque le dispositif de (multi)fonctionnalisation 12 comprend un aimant permanent, car ce dernier peut ainsi être maintenu à une température inférieure à sa température de Curie. Le secteur 100 et le dispositif de (multi)fonctionnalisation 12 qu'il loge étant ainsi constamment refroidies par de l'eau, la température des dispositifs de (multi)fonctionnalisation 12 ne peut pas excéder la température de travail du secteur 100, du moins dans la mesure où les dispositifs de (multi)fonctionnalisation 12 eux-mêmes n'émettent pas de chaleur de façon significative.

En alternative, le logement de (multi)fonctionnalisation 101 peut être distinct de la partie du canal de circulation s'étendant dans le secteur 100. Cette configuration alternative (non représentée sur les dessins) est à privilégier lorsqu'un contact entre le fluide caloporteur et le dispositif de (multi)fonctionnalisation 12 est à éviter. Plus particulièrement, un tel contact peut rendre le dispositif de (multi)fonctionnalisation 12 dysfonctionnel, ou moins fiable, précis, actif, etc.

De préférence, le dispositif de (multi)fonctionnalisation 12 est constitué à base d'un matériau moins bon conducteur électrique que le matériau, en général du cuivre, à base duquel les secteurs 100 sont constitués. De la sorte, l'on s'assure que les courants induits (courants de Foucault) par la spire extérieure 2 d'induction électromagnétique se situent en périphérie des secteurs 100 de la cage froide 10. Le cuivre étant en effet l'un des meilleurs conducteurs électriques connus, il agit alors comme un blindage électromagnétique. Ainsi, chaque dispositif de (multi)fonctionnalisation 12 introduit à l'intérieur d'un secteur 100 ne subit pas d'effet du champ (électro)magnétique.

En alternative ou en complément, le dispositif de (multi)fonctionnalisation 12 peut être agencé conjointement avec un support 12b, plus particulièrement un adaptateur, constitué à base d'un matériau moins bon conducteur électrique que le matériau à base duquel les secteurs 100 sont constitués. Ce matériau moins bon conducteur peut même être un isolant électrique, tel que du plastique. Ledit support 12b permet ainsi au secteur 100 de jouer son rôle de blindage électromagnétique, même si le dispositif de (multi)fonctionnalisation 12 est constitué à base d'un matériau aussi bon conducteur électrique, voire meilleur conducteur électrique, que le matériau à base duquel les secteurs 100 sont constitués.

Le support 12b peut en outre jouer le rôle d'adaptateur. En tant que tel, il peut en outre permettre d'adapter n'importe quel type de dispositifs de (multi)fonctionnalisation 12, qu'elles que soient sa forme et sa dimension, audit logement de (multi)fonctionnalisation 101 qui peut dès lors être de taille et de forme standardisées. La fabrication du creuset froid 1' selon l'invention s'en trouve faciliter et son coût réduit.

Lorsque le dispositif de (multi)fonctionnalisation 12 comprend, ou est constitué de, une ferrite, il peut être configuré pour concentrer les lignes de champ électromagnétique situées en périphérie du secteur 100 qui le loge. Plusieurs secteurs 100 pouvant loger un tel dispositif de (multi)fonctionnalisation 12, il est dès lors possible de concentrer les lignes de champ électromagnétique dans certains endroits du creuset froid 1', de façon indépendante et modulable, car chacun des secteurs 100 est indépendant.

Lorsque le dispositif de (multi)fonctionnalisation 12 comprend, ou est constitué de, un transducteur ultrasonore, il peut être configuré pour caractériser la charge 20 en fusion en mesurant les vitesses de déplacement de la matière en son sein.

Lorsque le dispositif de (multi)fonctionnalisation 12 comprend, ou est constitué de, un dispositif piézoélectrique, il peut être configuré pour introduire des ondes de pressions à l'intérieur de la charge 20, notamment en fusion.

Un mode de réalisation préféré de l'invention est décrit ci-dessous en référence aux figures 3 à 7. Dans ce mode de réalisation préféré, le dispositif de (multi)fonctionnalisation 12 comprend, ou est constitué de, un dispositif de génération de champ (électro)magnétique. Il est entendu que les caractéristiques ci-dessous détaillées peuvent être adaptées *mutatis mutandis* aux différents autres dispositifs de (multi)fonctionnalisation 12 décrits plus haut.

Le creuset froid 1' illustré sur la figure 3 comprend une cage froide 10 de forme sensiblement cylindrique délimitant un espace intérieur destiné à recevoir une charge à fondre. La cage froide 10 est plus particulièrement constituée d'une pluralité de secteurs 100. De façon connue, les secteurs 100 ne sont pas en conduction électrique les uns avec les autres par au moins une partie de leurs bords longitudinaux. Sur cette partie, une lame d'air peut être ménagée entre deux secteurs 100 adjacents. En alternative, chaque fente entre deux secteurs adjacents peut être remplie d'un insert magnétique. Un tel insert peut plus particulièrement être constitué à base d'un matériau composite magnétique doux.

Chaque secteur 100 du creuset froid 1' illustré sur la figure 3 est fixé par une base 130, jouant le rôle d'un dispositif de fixation et de maintien 13 des secteurs 100. Plus particulièrement, le dispositif 13 permet de fixer les secteurs 100 sur un dispositif de refroidissement 11 et permet de maintenir les secteurs 100 en une position spécifique les uns par rapport aux autres sur le dispositif de refroidissement 11. Ainsi fixés et maintenus, les secteurs 100 forment l'essentiel, voire la totalité, de la cage froide 10. En alternative, les secteurs peuvent partager ensemble une même base 130 sur laquelle ils seraient fixés et maintenus, la base étant à son tour fixée au dispositif de refroidissement 11.

Le creuset froid 1' illustré sur la figure 3 comprend donc un dispositif de refroidissement 11 du type à fluide caloporteur, par exemple de l'eau. Un tel dispositif de refroidissement 11 peut être tel que connu de l'art antérieur. Le creuset froid 1' selon l'invention peut donc ne pas nécessiter le développement ou même l'adaptation des dispositifs de refroidissement 11 connus qui peuvent donc avantageusement être utilisés tels quels.

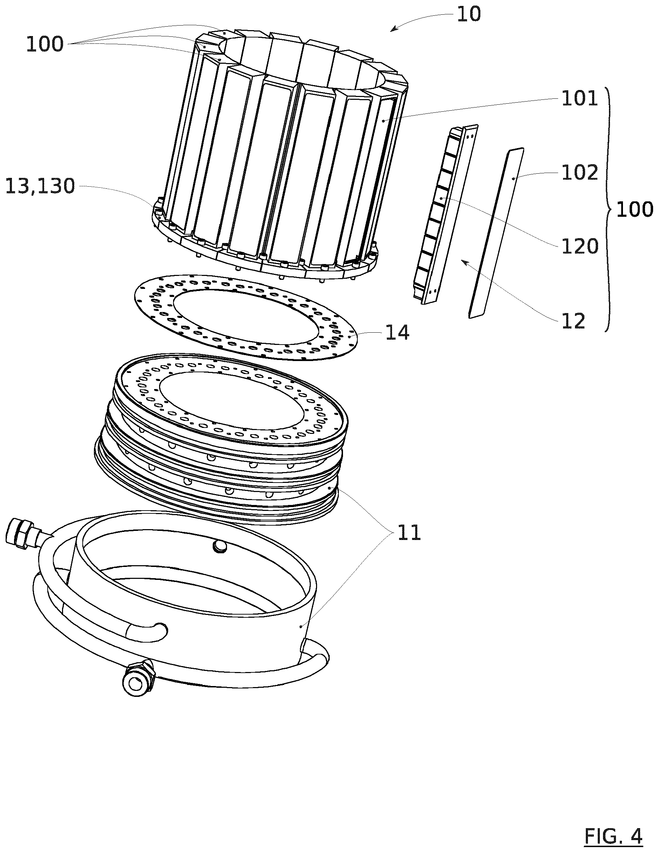

Comme illustré sur la figure 4, le dispositif de refroidissement 11 peut comprendre deux parties. Une première partie (en bas de la figure 4) par laquelle le fluide caloporteur est introduit dans, puis extrait depuis, une deuxième partie du dispositif de refroidissement 11 définissant un ou plusieurs circuits de circulation passant en partie à l'intérieur des secteurs 100 pour les refroidir.

Un joint 14, prenant la forme d'un joint de culasse dans l'exemple illustré sur la figure 4, peut-être disposé entre la deuxième partie du dispositif de refroidissement 11 et chaque base 130, de sorte à assurer une étanchéité entre ces pièces.

En alternative, les secteurs peuvent s'étendre par leur base 130 par une entrée et une sortie de fluide caloporteur faisant chacune saillie depuis la surface plane de la base 130 et étant chacune destinée à être insérée dans des alésages correspondants du dispositif de refroidissement ou d'une pièce intermédiaire (non représentée) entre le dispositif de refroidissement et l'ensemble des secteurs 100. L'étanchéité entre chaque secteur 100 et le dispositif de refroidissement 11 peut alors être réalisée par un ou plusieurs joints toriques répartis le long des saillies d'entrée et de sortie du fluide caloporteur.

Sur la figure 4, une vue partiellement éclatée de la cage froide 10 est également représentée. Les secteurs 100 sont fixés entre eux par leur base 130. Plus particulièrement, l'un des secteurs 100 est illustré en vue éclatée. Il apparaît ainsi que chaque secteur 100 comporte un logement 101 dans lequel le dispositif de génération est logé.

Plus particulièrement, le logement 101 peut être fermé, de préférence par son côté opposé à l'espace intérieur de la cage froide 10, par une plaque 102, en laiton ou en cuivre, fixée, de préférence par soudure, de sorte à être en conduction électrique avec les autres parois définissant le logement 101. Un creuset froid classique comprend en effet uniquement, en tant que cavité, une partie du canal de circulation du fluide caloporteur destiné à permettre son refroidissement ; il n'est donc a priori pas permis d'y loger un quelconque dispositif de (multi)fonctionnalisation 12, ici un dispositif de génération 120, du moins pas sans affecter le refroidissement du secteur. En alternative, chaque secteur 100 peut avoir été conçu de sorte à présenter un logement 101 propre et destiné à recevoir le dispositif de génération 120.

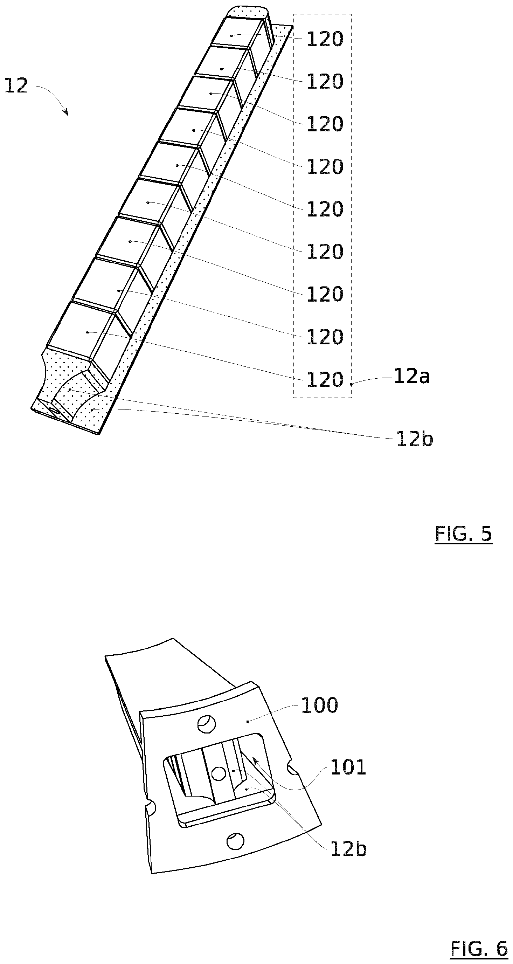

Le dispositif de génération 120 tel qu'illustré sur la figure 4 est plus particulièrement représenté sur la figure 5. Cette figure illustre en particulier le fait que, selon le mode de réalisation préféré de l'invention, le dispositif de génération 120 comprend essentiellement deux parties 12a et 12b. Une première partie 12a est configurée pour générer un champ magnétique statique. Une deuxième partie, dite partie de support, support ou adaptateur 12b est configurée pour supporter la première partie 12a du dispositif de génération. Plus particulièrement, la partie de support 12b comprend une plaque sensiblement longitudinale depuis laquelle s'étendent perpendiculairement deux éléments de maintien. La première partie 12a du dispositif de génération 120 est fixée et maintenue entre les deux éléments de maintien de la partie de support 12b. Les deux éléments de maintien sont en outre configurés de sorte à réserver une partie du circuit de circulation de fluide caloporteur dans le secteur 100, et plus particulièrement dans l'espace du logement 101 inoccupé par le dispositif de génération, autour de la première partie 12a du dispositif de génération. Ainsi, un premier des deux éléments de maintien (celui du bas de la figure 5) constitue un type d'îlot central de part et d'autre duquel le fluide caloporteur est destiné à circuler en sens opposés ; le second des deux éléments de maintien (celui du haut de la figure 5) constitue l'intérieur d'un méandre du circuit de circulation.

Une vue en perspective de dessous d'un des secteurs 100 illustré sur la figure 3 est illustrée sur la figure 6. Il y est illustré que le logement 101 peut être ouvert par sa base 130. Une série d'alésages traversant et/ou de retraits de matière peut être prévue dans des extensions de la base 130 à fin de fixation à des bases de secteurs adjacents et/ou de fixation au dispositif de refroidissement 11, notamment à travers le joint de culasse 14. Plus particulièrement, les retraits de matière de deux segments 100 adjacents entre eux peuvent être destinés à coopérer ensemble à fin de fixation de ces segments entre eux. Il est également illustré sur la figure 6 que le dispositif de génération est logé de façon étroite dans le logement 101. Notamment, la deuxième partie 12b comprend une plaque longitudinale configurée pour couvrir de préférence la totalité de la surface intérieure du logement 101 qui est à l'opposé de l'espace intérieur de la cage froide 10 ; et la surface de la première partie 12a du dispositif de génération est en appui, ou du moins en contact, avec la surface intérieure du logement 101 qui est orientée vers l'espace intérieur de la cage froide 10. De la sorte, le support 12b joue le rôle d'adaptateur permettant d'éviter tout mouvement du dispositif de génération dans son logement 101. Le dispositif de génération y est donc maintenu immobile. Ainsi, il apparaît également que l'ensemble formé du secteur 100 et du dispositif de génération adéquatement placé dans le secteur 100 définit la partie de circuit de circulation susmentionnée sous la forme d'un U débouchant par la base 130 du secteur 100. On remarque que, dans cette configuration, la première partie 12a du dispositif de génération, configurée pour générer le champ magnétique statique, est située au plus près de l'espace intérieur de la cage froide 10. Plus particulièrement, seule l'épaisseur de la paroi longitudinale du secteur 100 qui est orientée vers l'espace intérieur de la cage froide 10 sépare la première partie 12a du dispositif de génération et l'espace intérieur de la cage froide 10. L'épaisseur de cette paroi est par exemple comprise entre 0,5 et 2 mm, de préférence comprise entre 0,7 et 1,5 mm. Le support 12b joue donc là aussi un rôle d'adaptateur en ce sens qu'il permet de réaliser ou non un contact entre le dispositif de (multi)fonctionnalisation et les parois internes du secteur qui le loge.

L'on comprend que le dispositif de génération est ainsi plus particulièrement logé dans son secteur 100 de sorte à se situer, par son bord orienté vers l'intérieur de la cage froide 10, à une distance sensiblement inférieure à 12 mm, de préférence sensiblement inférieure à 9 mm, et encore plus préférentiellement sensiblement inférieure à 6 mm, de la charge 20 en fusion dans le creuset froid 1'.

En outre, il apparaît que, par construction, le dispositif de génération est configuré de sorte à être refroidi par le dispositif de refroidissement 11 déjà en charge du refroidissement du secteur 100 dans lequel le dispositif de génération est logé.

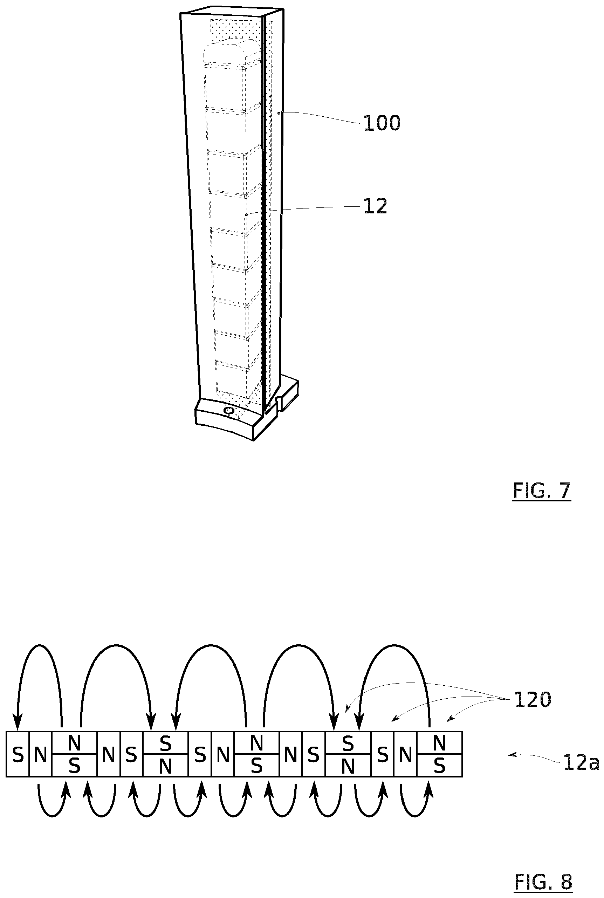

La première partie 12a du dispositif de génération selon le mode de réalisation préféré de l'invention est décrite ci-dessous en référence aux figures 5 et 7.

Comme illustré, la première partie 12a du dispositif de génération comprend, de façon non limitative, une pluralité de neuf aimants permanents 120. Dès lors, l'on comprend que le dispositif de refroidissement 11 est de préférence configuré et/ou paramétré pour garantir le maintien de chaque aimant permanent à une température strictement inférieure à la température de Curie de cet aimant ; sans quoi, l'aimantation de l'aimant permanent serait perdue.

Chaque aimant permanent peut présenter une géométrie sensiblement cubique, dont les arêtes sont par exemple sensiblement égales à 2 cm. Bien sûr, la géométrie et les dimensions de chaque aimant permanent doivent être adaptées aux dimensions du logement 101, et plus généralement du secteur 100. Chaque aimant permanent 120 peut plus particulièrement être constitué à base d'un alliage néodyme/fer/bore. Un tel alliage présente une résistivité électrique supérieure, et plus particulièrement au moins deux fois supérieure, à celle du cuivre constituant les secteurs 100 de la cage froide 10. Les aimants permanents 120 sont alignés entre eux et maintenus alignés par et entre les deux éléments de maintien de la partie de support 12b du dispositif de génération. Cet alignement est plus particulièrement tel que les aimants permanents 120 sont agencés entre eux selon une configuration dite de Halbach. Une telle configuration est connue pour permettre, comme illustré sur la figure 8, de générer, dans une direction perpendiculaire à l'alignement, un champ magnétique statique plus puissant que dans une autre direction perpendiculaire à l'alignement.

L'agencement de l'alignement sur la partie de support est corrélé à la disposition attendue du dispositif de génération dans le logement 101 de son secteur. Plus particulièrement, le dispositif de génération est disposé dans son logement 101 de sorte que le côté par lequel l'alignement des aimants permanents génère un champ magnétique statique plus puissant soit situé directement en regard de, et de préférence au contact de, la paroi longitudinale du secteur 100 qui est orientée vers l'espace intérieur de la cage froide 10.

Avec des aimants permanents tels qu'introduits ci-dessus à titre exemplatif, le champ magnétique généré par l'alignement Halbach présente une densité maximale à 2 mm sensiblement égale à 0,6 T et présente encore une densité maximale à 12 mm sensiblement égale à 0,1 T.

On comprend donc que, notamment selon cet agencement particulier, le dispositif de génération est configuré pour générer un champ magnétique statique de densité suffisante pour être ressenti par la charge 20 en fusion dans la cage froide 10, et plus particulièrement au moins dans une épaisseur de peau électromagnétique 21 de la charge en fusion dans la cage froide.

Plus particulièrement, le champ magnétique statique généré par le dispositif de génération est tel qu'il présente une densité sensiblement supérieure à 0,02 T, de préférence sensiblement supérieure à 0,05 T, à une distance sensiblement supérieure à 2 mm depuis son bord orienté vers l'intérieur de la cage froide 10.

En alternative ou en complément, le champ magnétique statique généré par le dispositif de génération est tel qu'il présente une densité sensiblement comprise entre 0,07 et 0,8 T à une distance sensiblement comprise entre 0,1 et 12 mm depuis son bord orienté vers l'intérieur de la cage froide 10. De préférence, le champ magnétique statique généré par le dispositif de génération est tel qu'il présente une densité sensiblement comprise entre 0,1 et 0,3 T à une distance sensiblement comprise entre 4 et 10 mm, depuis un des bords du dispositif de génération orienté vers l'intérieur de la cage froide 10.

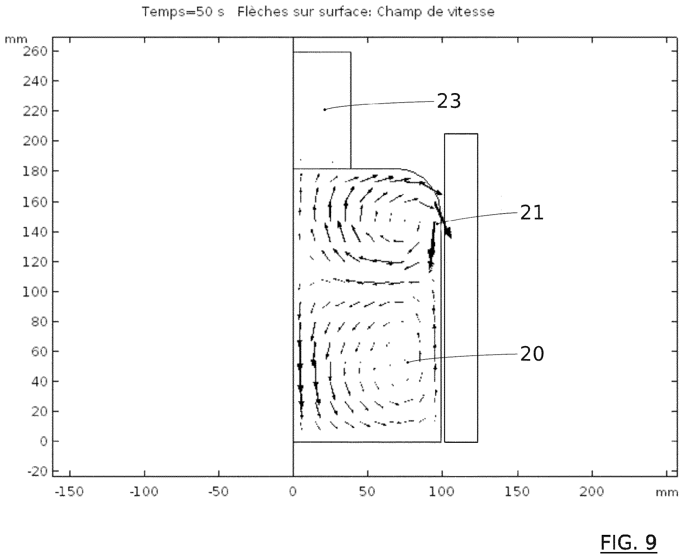

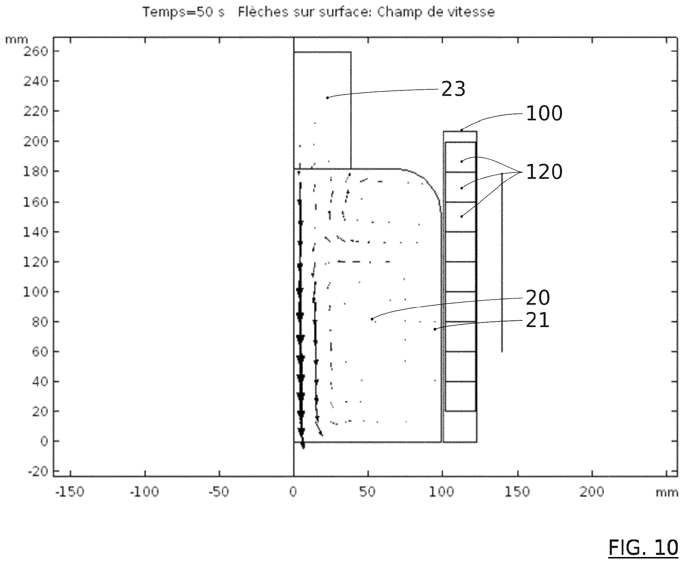

Un modèle numérique multi-physique a été développé qui permet de montrer l'efficacité du creuset froid 1' selon le mode de réalisation préféré de l'invention. Sur la figure 10, nous montrons que l'utilisation des aimants permanents 120 dans les secteurs 100 modifie de façon non négligeable l'écoulement de la charge 20 en fusion (dans la simulation, le matériau est porté à une température sensiblement égale à 1690°C) dans le creuset froid 1'. Cette modification se traduit par un freinage intense des vitesses de brassage dans les zones de la charge 20 en fusion les plus proches du creuset froid 1', mais aussi par une inversion des vortex de brassages, ceux-ci adoptant un sens de rotation plus favorable à la croissance d'un monocristal à partir d'un germe 23 que dans un creuset froid conventionnel (figure 9).

Le creuset froid 1' selon l'invention permet donc d'une part de ralentir le brassage qui serait observé dans un creuset froid classique, d'autre part d'inverser le sens de recirculation des vortex induits dans la charge 20 en fusion.

L'utilisation d'un creuset froid « magnétique » selon le mode de réalisation préféré de l'invention permet, notamment par synergie des deux effets techniques énoncés ci-dessus, de favoriser la croissance de monocristaux de plus grande taille qu'un creuset froid classique. Plus particulièrement, l'utilisation d'un creuset froid « magnétique » selon le mode de réalisation préféré de l'invention permet de favoriser la croissance de monocristaux de plus grand diamètre que le diamètre du germe initiant la croissance et de meilleure qualité que celle obtenue par les techniques mettant en oeuvre des creusets chauds.

Un autre avantage lié à l'utilisation de creusets froids « magnétiques » selon le mode de réalisation préféré de l'invention apparaît lorsque l'on considère une charge constituée de différents matériaux présentant des différences de susceptibilité magnétique entre eux. Par exemple, une telle charge peut comprendre des matériaux ferromagnétique, paramagnétique ou diamagnétique. Un creuset froid « magnétique » selon le mode de réalisation préféré de l'invention peut alors permettre, du fait de la présence d'un gradient de champ magnétique statique s'étendant jusque dans la charge 20 en fusion, un tri sélectif de ces matériaux.

D'autres avantages peuvent être atteints via l'utilisation d'un creuset froid 1' selon le mode de réalisation préféré de l'invention, notamment par intégration à l'intérieur de secteurs dont les logements 101 ne sont pas occupés par des dispositifs de génération et/ou permettent de loger au moins l'un parmi les autres dispositifs de (multi)fonctionnalisation précédemment décrits.

D'autres avantages peuvent encore être atteints via l'utilisation d'un creuset froid 1' selon le mode de réalisation préféré de l'invention, notamment par l'agencement entre eux des secteurs 100 logeant des dispositifs de génération. Ces secteurs 100 peuvent en effet être agencés de l'une des façons suivantes :

- seuls deux secteurs opposés l'un à l'autre logent un dispositif de génération ;
- seuls trois secteurs agencés sensiblement selon une symétrie de rotation d'ordre 3 logent un dispositif de génération ;
- seuls quatre secteurs agencés sensiblement selon une symétrie de rotation d'ordre 4 logent un dispositif de génération ;
- un secteur sur deux secteurs adjacents loge un dispositif de génération ; et
- chaque secteur loge un dispositif de génération.

Outre, l'élaboration de monocristaux d'oxyde, tels que du saphir, le creuset froid 1' selon le mode de réalisation préféré de l'invention permet d'élaborer des lingots de silicium monocristallin de grandes dimensions, et en particulier de grand diamètre, notamment en vue d'applications dans le domaine de l'électronique de puissance.

L'invention n'est pas limitée aux modes de réalisations précédemment décrits et s'étend à tous les modes de réalisation couverts par les revendications.

Notamment, chaque dispositif de génération n'est pas limité à son mode de réalisation comprenant au moins un aimant permanent. En effet, il est par exemple envisageable, bien que non préférentiel pour des raisons de difficultés de raccordement électrique notamment, que le champ soit électromagnétique et puisse être généré par au moins un électroaimant. Dès lors que le courant d'alimentation d'un tel électroaimant peut varier dans le temps faisant varier le champ magnétique généré par cet électroaimant, l'on comprend que le champ électromagnétique généré par un dispositif de génération dans un creuset froid 1' selon le mode de réalisation préféré de l'invention n'est pas nécessairement limité à un champ magnétique statique ; notamment, le champ électromagnétique généré par le dispositif de génération peut être un champ magnétique quasi statique.

Par ailleurs, le forme des secteurs n'est pas limitée à une forme sensiblement parallélépipédique comme représentée sur les figures 3 à 7, mais s'étend à n'importe quelle forme permettant aux secteurs 100 fixés et maintenus ensemble de former l'essentiel, voire la totalité de la cage froide 10. Par exemple, chaque secteur peut prendre sensiblement la forme d'un pétale, et formé avec les autres la cage froide, d'une façon comparable à la formation d'une corolle par les pétales d'une fleur.

## Revendications

1. Creuset froid (1') comprenant :

   - une cage dite froide (10) comprenant des secteurs (100) en un matériau bon conducteur électrique, généralement en cuivre, et dans laquelle une charge (20) à fondre est destinée à être introduite, et

- un dispositif de refroidissement (11) à fluide caloporteur, généralement de l'eau,

le dispositif de refroidissement (11) étant configuré pour refroidir, de l'intérieur, chaque segment (100) de la cage froide (10),

le creuset froid (1') étant tel qu'au moins un des secteurs (100) du creuset froid (1') comprend un logement dit de fonctionnalisation (101) propre et destiné à y loger au moins un dispositif de fonctionnalisation (12, 120) du creuset froid,

le creuset froid (1') étant **caractérisé en ce qu'**au moins un des secteurs (100) du creuset froid (1') est amovible.

2. Creuset froid (1') selon la revendication précédente, dans lequel ledit au moins un dispositif de fonctionnalisation (12, 120) comprend, voire est constitué de, un dispositif de modification et/ou d'analyse d'au moins une propriété de la charge (20), notamment en fusion, dans la cage froide (10).

3. Creuset froid (1') selon l'une quelconque des revendications précédentes, comprenant en outre un dispositif de fixation et de maintien (13, 130) dudit au moins un secteur (100) amovible, à l'un au moins parmi le dispositif de refroidissement (11) et au moins un autre secteur (100), le dispositif de fixation et de maintien (13, 130) étant configuré de sorte que ledit au moins un secteur (100) amovible une fois fixé et maintenu forme une partie de la cage froide (10).

4. Creuset froid (1') selon l'une quelconque des revendications précédentes, dans lequel, le dispositif de refroidissement (11) comprenant un canal de circulation du fluide caloporteur configuré pour permettre le refroidissement de la cage froide et s'étendant en partie dans au moins un des secteurs, de préférence dans chaque secteur, le logement de fonctionnalisation (101) est en communication avec la partie du canal de circulation s'étendant dans ledit secteur, de sorte que ledit au moins un dispositif de fonctionnalisation (12, 120) soit lui-aussi refroidi par le dispositif de refroidissement (11) du creuset froid (1').

5. Creuset froid (1') selon l'une quelconque des revendications précédentes, dans lequel le dispositif de fonctionnalisation (12, 120) est constitué à base d'un matériau moins bon conducteur électrique que le matériau, en général du cuivre, à base duquel les secteurs (100) sont constitués.

6. Creuset froid (1') selon l'une quelconque des revendications précédentes, dans lequel le dispositif de fonctionnalisation (12, 120) peut être agencé conjointement avec un support (12b) configuré pour adapter ledit au moins un dispositif de fonctionnalisation (12, 120) audit logement de fonctionnalisation (101).

7. Creuset froid (1') selon la revendication précédente, dans lequel ledit support (12b) est constitué à base d'un matériau moins bon conducteur électrique que le matériau, en général du cuivre, à base duquel les secteurs sont constitués.

8. Creuset froid (1') selon l'une quelconque des revendications 6 et 7, dans lequel ledit support (12b) isole électriquement le dispositif de fonctionnalisation (12, 120) et celui des secteurs (100) qui le loge entre eux.

9. Creuset froid (1') selon l'une quelconque des revendications précédentes, dans lequel ledit au moins un dispositif de fonctionnalisation (12, 120) comprend au moins l'un choisi parmi :

- un dispositif de génération d'un champ électromagnétique, de préférence un aimant permanent,
- une ferrite,
- un dispositif de chauffage complémentaire,
- un transducteur ultrasonore et
- un dispositif piézoélectrique.

10. Creuset froid (1') selon la revendication précédente, dans lequel, ledit au moins un dispositif de fonctionnalisation (12, 120) comprenant une ferrite, il est configuré pour concentrer les lignes de champ électromagnétique situées en périphérie du secteur (100) qui le loge.

11. Creuset froid (1') selon l'une quelconque des revendications 9 et 10, dans lequel, ledit au moins un dispositif de fonctionnalisation (12, 120) comprenant un transducteur ultrasonore, il est configuré pour caractériser la charge (20) en fusion en mesurant les vitesses de déplacement de la matière en son sein.

12. Creuset froid (1') selon l'une quelconque des revendications 9 à 11, dans lequel, ledit au moins un dispositif de fonctionnalisation (12, 120) comprenant un dispositif piézoélectrique, il est configuré pour introduire des ondes de pressions à l'intérieur de la charge (20), notamment en fusion.

13. Creuset froid (1') selon l'une quelconque des revendications 9 à 12, dans lequel ledit au moins un dispositif de fonctionnalisation (12, 120) comprenant un dispositif de génération (120) d'un champ électromagnétique, configuré pour générer un champ électromagnétique, de préférence un champ magnétique statique, de densité suffisante pour être ressenti par la charge (20) en fusion dans la cage froide (10), et plus particulièrement au moins dans une épaisseur de peau électromagnétique (21) de la charge en fusion dans la cage froide.

**14.** Creuset froid (1') selon la revendication 13, dans lequel le dispositif de génération (120) comprend au moins un aimant permanent.

**15.** Creuset froid (1') selon l'une quelconque des revendications précédentes, dont les secteurs (100) sont agencés de l'une des façons suivantes :

- seuls deux des secteurs, opposés l'un à l'autre, logent un dispositif de fonctionnalisation (12, 120) ;
- seuls trois des secteurs, agencés sensiblement selon une symétrie de rotation d'ordre 3, logent un dispositif de fonctionnalisation (12, 120) ;
- seuls quatre des secteurs, agencés sensiblement selon une symétrie de rotation d'ordre 4, logent un dispositif de fonctionnalisation (12, 120) ;
- un secteur sur deux secteurs adjacents loge un dispositif de fonctionnalisation (12, 120) ; et
- chaque secteur loge un dispositif de fonctionnalisation (12, 120).

**Patentansprüche**

**1.** Kaltschmelztiegel (1'), umfassend:

- einen sogenannten Kalttiegel (10), umfassend Sektoren (100) aus einem gut elektrisch leitenden Material, im Allgemeinen aus Kupfer, und in den eine zu schmelzende Charge (20) eingebracht werden soll, und
- eine Kühlvorrichtung (11) mit einer Wärmeträgerflüssigkeit, im Allgemeinen Wasser, wobei die Kühlvorrichtung (11) dazu konfiguriert ist, im Inneren jedes Segment (100) des Kalttiegels (10) zu kühlen, wobei der Kaltschmelztiegel (1') so ist, dass mindestens einer der Sektoren (100) des Kaltschmelztiegels (1') ein sogenanntes Funktionalisierungsgehäuse (101) umfasst, das dazu geeignet und vorgesehen ist, mindestens eine Funktionalisierungsvorrichtung (12, 120) des Kaltschmelztiegels darin zu beherbergen, wobei der Kaltschmelztiegel (1') **dadurch gekennzeichnet ist, dass** mindestens einer der Sektoren (100) des Kaltschmelztiegels (1') herausnehmbar ist.

**2.** Kaltschmelztiegel (1') nach dem vorhergehenden Anspruch, wobei die mindestens eine Funktionalisierungsvorrichtung (12, 120) eine Vorrichtung zur Modifikation und/oder Analyse von mindestens einer Eigenschaft der Charge (20), insbesondere der geschmolzenen Charge in dem Kalttiegel (10) umfasst, sogar daraus besteht.

**3.** Kaltschmelztiegel (1') nach einem der vorhergehenden Ansprüche, weiterhin umfassend eine Vorrichtung (13, 130) zur Fixieren und Halten des mindestens einen herausnehmbaren Sektor (100) an mindestens einer bzw. einem von der Kühlvorrichtung (11) und mindestens einem anderen Sektor (100), wobei die Fixierungs- und Haltevorrichtung (13, 130) konfiguriert ist, so dass der mindestens eine herausnehmbare Sektor (100), sobald er fixiert und gehalten wird, einen Teil des Kalttiegels (10) bildet.

**4.** Kaltschmelztiegel (1') nach einem der vorhergehenden Ansprüche, wobei die Kühlvorrichtung (11) einen Kanal zur Zirkulation der Wärmeträgerflüssigkeit umfasst, der dazu konfiguriert ist, die Kühlung des Kalttiegels zu ermöglichen, und der sich zum Teil in mindestens einem der Sektoren, vorzugsweise in jedem Sektor erstreckt, wobei das Funktionalisierungsgehäuse (101) in Verbindung mit dem Teil des Zirkulationskanals ist, der sich in dem Sektor erstreckt, so dass die mindestens eine Funktionalisierungsvorrichtung (12, 120) selbst ebenfalls von der Kühlvorrichtung (11) des Kaltschmelztiegels (1') gekühlt wird.

**5.** Kaltschmelztiegel (1') nach einem der vorhergehenden Ansprüche, wobei die Funktionalisierungsvorrichtung (12, 120) auf einem weniger gut elektrisch leitenden Material basiert als das Material, im Allgemeinen Kupfer, auf dem die Sektoren (100) basieren.

**6.** Kaltschmelztiegel (1') nach einem der vorhergehenden Ansprüche, wobei die Funktionalisierungsvorrichtung (12, 120) zusammen mit einem Träger (12b) eingerichtet sein kann, der dazu konfiguriert ist, die mindestens eine Funktionalisierungsvorrichtung (12, 120) an das Funktionalisierungsgehäuse (101) anzupassen.

**7.** Kaltschmelztiegel (1') nach dem vorhergehenden Anspruch, wobei der Träger (12b) auf einem weniger gut elektrisch leitenden Material basiert als das Material, im Allgemeinen Kupfer, auf dem die Sektoren basieren.

**8.** Kaltschmelztiegel (1') nach einem der Ansprüche 6 und 7, wobei der Träger (12b) die Funktionalisierungsvorrichtung (12, 120) und den einen der Sektoren (100), der sie dazwischen beherbergt, elektrisch isoliert.

**9.** Kaltschmelztiegel (1') nach einem der vorhergehenden Ansprüche, wobei die mindestens eine Funktionalisierungsvorrichtung (12, 120) mindestens eine Komponente umfasst, ausgewählt aus:

- eine Vorrichtung zur Erzeugung eines elektromagnetischen Felds, vorzugsweise ein Dauermagnet,
- einem Ferrit,
- einer Zusatzheizvorrichtung,
- einem Ultraschallwandler und
- einer piezoelektrischen Vorrichtung.

10. Kaltschmelztiegel (1') nach dem vorhergehenden Anspruch, wobei, wenn die mindestens eine Funktionalisierungsvorrichtung (12, 120) einen Ferrit umfasst, sie dazu konfiguriert ist, die Linien des elektromagnetischen Felds zu konzentrieren, die sich im Umkreis des Sektors (100) befinden, der sie beherbergt.

11. Kaltschmelztiegel (1') nach einem der Ansprüche 9 und 10, wobei, wenn die Funktionalisierungsvorrichtung (12, 120) einen Ultraschallwandler umfasst, sie dazu konfiguriert ist, die geschmolzene Charge (20) durch Messen der Bewegungsgeschwindigkeiten des Materials darin zu charakterisieren.

12. Kaltschmelztiegel (1') nach einem der Ansprüche 9 bis 11, wobei, wenn die mindestens eine Funktionalisierungsvorrichtung (12, 120) eine piezoelektrische Vorrichtung umfasst, sie dazu konfiguriert ist, Druckwellen in das Innere der Charge (20), insbesondere der geschmolzenen Charge zu beherbergen.

13. Kaltschmelztiegel (1') nach einem der Ansprüche 9 bis 12, wobei die mindestens eine Funktionalisierungsvorrichtung (12, 120) eine Vorrichtung (120) zur Erzeugung eines elektromagnetischen Felds umfasst, die dazu konfiguriert ist, ein elektromagnetisches Feld, vorzugsweise ein statisches Magnetfeld mit einer Dichte zu erzeugen, die dazu ausreicht, von der geschmolzenen Charge (20) in dem Kalttiegel (10) und ganz besonders mindestens in einer elektromagnetischen Eindringtiefe (21) der geschmolzenen Charge in dem Kalttiegel gefühlt zu werden.

14. Kaltschmelztiegel (1') nach Anspruch 13, wobei die Erzeugungsvorrichtung (120) mindestens einen Dauermagneten umfasst.

15. Kaltschmelztiegel (1') nach einem der vorhergehenden Ansprüche, deren Sektoren (100) auf eine der folgenden Weisen eingerichtet sind:

- nur zwei der Sektoren, zueinander entgegengesetzt, beherbergen eine Funktionalisierungsvorrichtung (12, 120);
- nur drei der Sektoren, im Wesentlichen gemäß einer Rotationssymmetrie der 3. Ordnung eingerichtet, beherbergen eine Funktionalisierungsvorrichtung (12, 120);
- nur vier der Sektoren, im Wesentlichen gemäß einer Rotationssymmetrie der 4. Ordnung eingerichtet, beherbergen eine Funktionalisierungsvorrichtung (12, 120);
- ein Sektor von zwei benachbarten Sektoren beherbergt eine Funktionalisierungsvorrichtung (12, 120) und
- jeder Sektor beherbergt eine Funktionalisierungsvorrichtung (12, 120).

**Claims**

1. A cold crucible (1') comprising:

- a so-called cold cage (10) comprising sectors (100) made of a good electrical conductor material, copper in general, and within which a charge (20) to be molten is intended to be introduced, and
- a cooling device (11) with a heat-transfer fluid, water in general,
the cooling device (11) being configured so as to cool down, from inside, each segment (100) of the cold cage (10),
the cold crucible (1') being such that at least one of the sectors (100) of the cold crucible (1') comprises a so-called functionalising housing (101) able and intended to accommodate therein at least one functionalising device (12, 120) of the cold crucible,
the cold crucible (1') being **characterised in that** at least one of the sectors (100) of the cold crucible (1') is removable.

2. The cold crucible (1') according to the preceding claim, wherein said at least one functionalising device (12, 120) comprises, and possibly consists of, a device for modifying and/or analysing at least one property of the charge (20), in particular the molten charge, in the cold cage (10).

3. The cold crucible (1') according to any one of the preceding claims, further comprising a device for fastening and holding (13, 130) said at least one removable sector (100), to at least one amongst the cooling device (11) and at least one other sector (100), the fastening and holding device (13, 130) being configured so that, once fastened and held, said at least one removable sector (100) forms a portion of the cold cage (10).

4. The cold crucible (1') according to any one of the preceding claims, wherein, the cooling device (11) comprising a circulation channel of the heat-transfer fluid configured so as to enable cooling of the cold cage and extending partially in at least one of the sectors, preferably in each sector, the functionalising housing (101) is in communication with the portion of the circulation channel extending in said sector, so that said at least one functionalising device (12, 120) is, in turn, cooled by the cooling device (11) of the cold crucible (1').

5. The cold crucible (1') according to any one of the preceding claims, wherein the functionalising device (12, 120) is constructed based on a material that is less good electrical conductor than the material, copper in general, the sectors (100) are made of.

6. The cold crucible (1') according to any one of the preceding claims, wherein the functionalising device (12, 120) may be arranged together with a support (12b) configured so as to adapt said at least one functionalising device (12, 120) at said functionalising housing (101).

7. The cold crucible (1') according to the preceding claim, wherein said support (12b) is constructed based on a material that is less good electrical conductor than the material, copper in general, the sectors are made of.

8. The cold crucible (1') according to any one of claims 6 and 7, wherein said support (12b) electrically isolates the functionalising device (12, 120) and that one amongst the sectors (100) that accommodates it therebetween.

9. The cold crucible (1') according to any one of the preceding claims, wherein said at least one functionalising device (12, 120) comprises at least one amongst:

    - a device for generating an electromagnetic field, preferably a permanent magnet,
    - a ferrite,
    - a complementary heating device,
    - an ultrasonic transducer, and
    - a piezoelectric device.

10. The cold crucible (1') according to the preceding claim, wherein, said at least one functionalising device (12, 120) comprising a ferrite, it is configured so as to concentrate the electromagnetic field lines located at the periphery of the sector (100) that accommodates it.

11. The cold crucible (1') according to any one of claims 9 and 10, wherein, said at least one functionalising device (12, 120) comprising an ultrasonic transducer, it is configured so as to characterise the molten charge (20) by measuring the speeds of displacement of the matter therewithin.

12. The cold crucible (1') according to any one of claims 9 to 11, wherein, said at least one functionalising device (12, 120) comprising a piezoelectric device, it is configured so as to introduce pressure waves within the charge (20), in particular the molten charge.

13. The cold crucible (1') according to any one of claims 9 to 12, wherein said at least one functionalising device (12, 120) comprising a device (120) for generating an electromagnetic field, configured so as to generate an electromagnetic field, preferably a static magnetic field, with enough density to be felt by the molten charge (20) in the cold cage (10), and more particularly at least across an electromagnetic skin thickness (21) of the molten charge in the cold cage.

14. The cold crucible (1') according to claim 13, wherein the generation device (120) comprises at least one permanent magnet.

15. The cold crucible (1') according to any one of the preceding claims, whose sectors (100) are arranged in one of the following ways:

    - only two of the sectors, opposite to one another, accommodate a functionalising device (12, 120);
    - only three of the sectors, arranged substantially according to a 3-order rotational symmetry, accommodate a functionalising device (12, 120);
    - only four of the sectors, arranged substantially according to a 4-order rotational symmetry, accommodate a functionalising device (12, 120);
    - one sector out of two adjacent sectors accommodates a functionalising device (12, 120); and
    - each sector accommodates a functionalising device (12, 120).

FIG. 1

FIG. 2

1'

10

100

13,130

11

FIG. 3

FIG. 4

FIG. 5

FIG. 6

FIG. 7

FIG. 8

Temps=50 s   Flèches sur surface: Champ de vitesse

FIG. 9

Temps=50 s   Flèches sur surface: Champ de vitesse

FIG. 10

**EP 3 921 462 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- DE 10042151 A1
- US 20070147463 A1
- JP H1152095 A
- US 5109389 A
- WO 2017093165 A1